Europäisches Patentamt

European Patent Office

Office européen des brevets

(19)

(11)    EP 0 971 480 A1

(12)    **DEMANDE DE BREVET EUROPEEN**

(43) Date de publication:
**12.01.2000   Bulletin 2000/02**

(51) Int Cl.⁷: **H03H 17/06**

(21) Numéro de dépôt: **99401652.5**

(22) Date de dépôt: **02.07.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **06.07.1998  FR 9808612**

(71) Demandeur: **STMicroelectronics SA**
**94250 Gentilly Cedex (FR)**

(72) Inventeur: **Urso, Pietro**
**38000 Grenoble (FR)**

(74) Mandataire: **Poulin, Gérard et al**
**Société de Protection des Inventions**
**Groupe Brevatome,**
**3, rue du docteur Lancereaux**
**75008 Paris (FR)**

(54)    **Filtre décimateur suréchantillonné parallèle**

(57)    La présente invention concerne un filtre décimateur qui comprend au moins trois filtres identiques
sous-échantillonnés (33, 34 ; 33', 34' ; 33", 34") déphasés entre eux et disposés en parallèle et un interpolateur
(35, 35' ; 35", 38) disposé en sortie de ceux-ci.

FIG. 4

## Description

Domaine technique

La présente invention concerne un filtre décimateur suréchantillonné parallèle, permettant notamment une récupération de phase numérique avec une granularité (ou précision minimale) de 1 ns dans des modems d'interface U RNIS (réseau numérique à intégration de services).

État de la technique antérieure

Le réseau RNIS est un réseau de communication tout numérique offrant la possibilité de transmettre voix, données et vidéo en utilisant une largeur de bande qui est augmentée des 3 kHz du téléphone analogique aux 144 kbps fournis par les canaux B voix/données. L'idée de base d'un tel réseau consiste à déplacer le point de conversion analogique-numérique du central chez l'abonné, le signal transmis sur le câble cuivre standard étant ainsi un signal numérique.

Avec le débit d'accès de base, chaque terminal abonné est relié au central par deux canaux B et un canal D (2B + 1D). Pour cet accès de base chaque canal B représente un train de données de 64 kbps et le canal D représente un flux de 16 kbps.

Une structure RNIS pour une connexion accès de base comprend notamment :

- une terminaison ligne LT ;
- une terminaison réseau NT ;
- un interface U qui fait le lien entre les terminaisons LT et NT ;
- au moins un équipement terminal TE.

La terminaison ligne LT réalise la fonction d'envoi et de réception des 2B + D canaux échangés par le central et l'équipement utilisateur en adaptant le format de données typique de l'interface U avec le format de données du bus interne du central.

La transmission numérique sur boucles cuivres à deux fils a évolué ces dernières années avec la transmission avec interface U, dans le cas particulier de la réception d'accès RNIS à débit de base. La norme ANSI exige une transmission de données de type duplex intégral à 160 kbits/s utilisant un code ligne de type 2B1Q avec suppression d'écho et récupération du temps. Du côté terminaison réseau (NT) les horloges d'émission et de réception sont synchrones, mais du côté terminaison ligne (LT) un algorithme robuste, permettant de synchroniser les données reçues vers les données émises, est nécessaire.

Pour de futures applications il est souhaitable de pouvoir stocker la différence de phase entre l'horloge d'émission (BCLK) et l'horloge de réception (RXBCLK) afin de mesurer précisément le temps de transit.

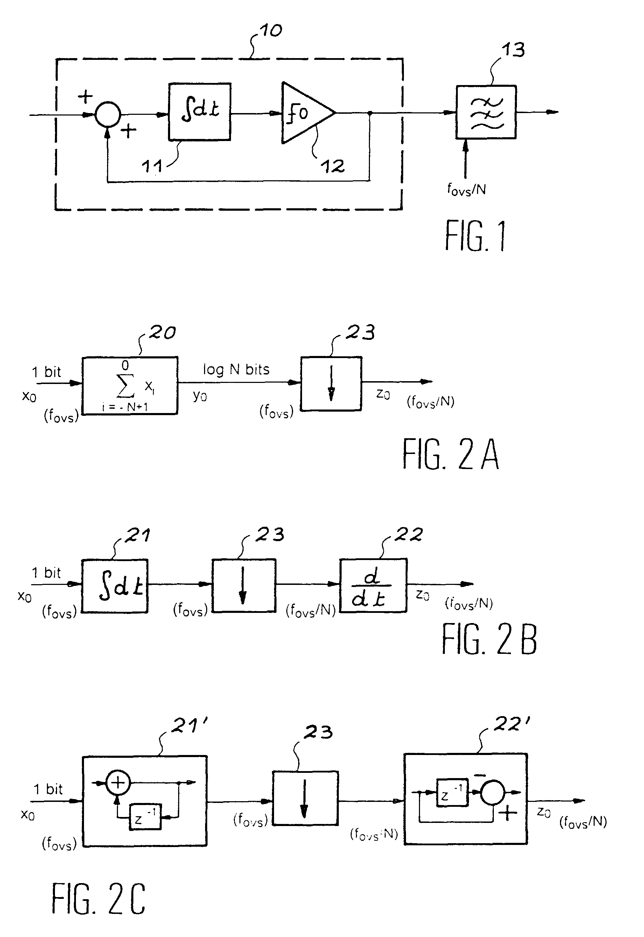

Dans la mise en oeuvre d'une boucle à verrouillage de phase (PLL) pour la récupération de phase, l'erreur d'estimation de phase d'échantillonnage est entrée dans un bloc de génération d'horloge pour ajuster la phase de l'horloge utilisée pour la décimation du signal reçu. Dans un dispositif de l'art connu illustré sur la figure 1, un convertisseur analogique/numérique de type sigma-delta 10, comprenant un intégrateur 11 et un convertisseur analogique/numérique 12 (quantification à seuil (1 bit)), délivre un échantillon à une fréquence de suréchantillonnage invariante dans le temps, fournie par un bloc de génération d'horloge. Ce convertisseur 10 est suivi d'un filtre passe-bas de décimation 13.

Ce filtre a la fonction de transfert suivante :

$$\left(\frac{1}{1-z^{-1}}\right)^3 \left(1-z^{-ovs}\right)^3$$

où ovs est le facteur de suréchantillonnage, par exemple 192.

Ce filtre 13, dont la structure est représentée sur les figures 2A, 2B, et 2C, réalise une moyenne mobile de 192 échantillons d'entrée à un bit. Il fournit aussi la fonction de limitation de bande nécessaire pour limiter le couplage parasite d'extrémité et le bruit de quantification. Une telle structure est fiable et de faible consommation.

Les figures 2A, 2B et 2C sont trois représentations équivalentes. Le filtre passe-bas 20 de la figure 2A est remplacé dans les figures 2B et 2C par un intégrateur 21 (ou 21') et un dérivateur 22 (ou 22') situés de part et d'autre d'un module de sous-échantillonnage 23. Ainsi les intégrateurs 21 ou 21', utilisés au débit de suréchantillonnage, sont suivis des modules de décimation 23 ou 23', puis de modules de dérivation 22 ou 22'.

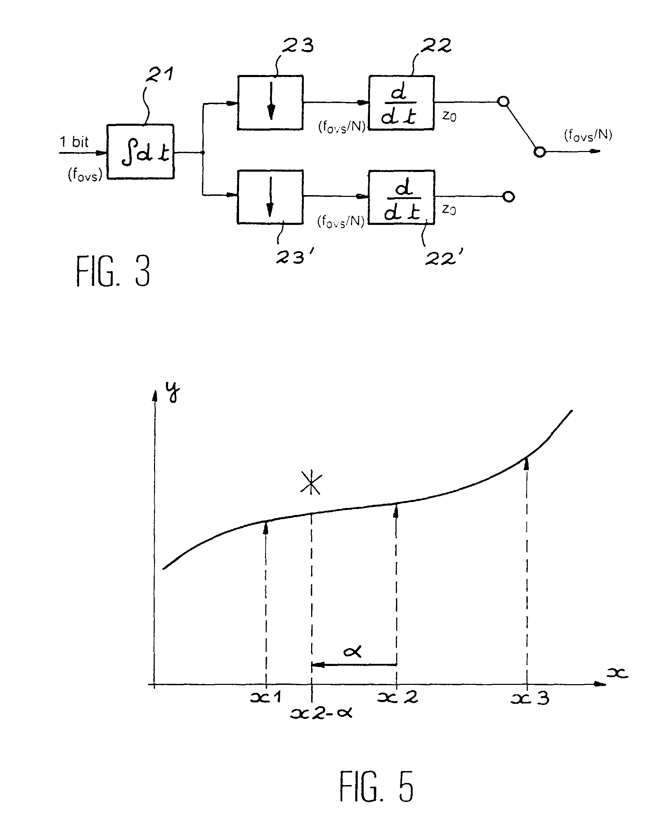

Pendant le processus de sous-échantillonnage la phase d'échantillonnage de l'horloge est ajustée par l'algorithme de récupération du temps. Une telle caractéristique nécessite une structure parallèle pour éviter les surdépassements de sortie étrangers qui, pour les filtres d'ordre élevé, nécessitent une longue période d'établissement. La solution la plus simple, représentée à la figure 3, comporte deux voies parallèles, en sortie de l'intégrateur 21, comprenant chacune un module de sous-échantillonnage 23 ou 23' suivi d'un dérivateur 22 ou 22', et fournit un échantillon de sortie fiable commutant sur une voie invariante en temps, quand la voie directe doit réaliser un saut en phase. La voie ainsi « évitée » est réutilisable seulement après le temps d'établissement qui dépend de l'ordre du filtre. Lorsque l'on utilise un filtre du troisième ordre, le temps d'établissement est égal à trois périodes de l'horloge.

Un document de l'art connu, référencé [1] en fin de description, décrit un module de traitement de signal numérique pour un émetteur RNIS au standard ANSI (American National Standards Institute). Ce module caractérise une architecture multiprocesseur, dans laquelle chaque processeur est optimisé.

Un autre document de l'art connu, référencé [2] en fin de description, décrit une technique de la décimation deux-phases. Lorsque cette technique est combinée avec une technique connue de compensation d'instabilité (« jitter »), elle permet de préserver la performance de l'annulateur d'écho dans un émetteur de données « full duplex » (ou duplex intégral) en présence de sauts de phase générés par la boucle à verrouillage de phase et de récupération d'horloge, et de changements rapides dans la phase d'échantillonnage du signal d'entrée.

L'invention a pour objet un filtre décimateur permettant de réaliser un algorithme de récupération de phase tout en évitant l'instabilité du convertisseur delta-sigma due à l'ajustement de la phase d'échantillonnage.

Exposé de l'invention

La présente invention concerne un filtre décimateur comprenant au moins trois filtres identiques sous-échantillonnés déphasés entre eux et disposés en parallèle, caractérisé en ce qu'il comprend un interpolateur disposé en sortie de ceux-ci.

Dans un exemple de réalisation ce filtre comprend un intégrateur triple dont la sortie est envoyée sur trois voies parallèles comportant chacune successivement un bloc de sous-échantillonnage, un dérivateur et un multiplieur, les sorties des trois multiplieurs étant envoyées dans un additionneur.

Les signaux d'entrée de chacune de ces voies sont décalés d'un délai égal à une période de la fréquence suréchantillonnée, grâce à des retards. Chaque bloc de sous-échantillonnage et chaque multiplieur a une seconde entrée qui reçoit un signal en provenance d'une machine d'état.

Dans un autre exemple de réalisation ce filtre comprend un intégrateur triple, suivi d'un registre à décalage à au moins trois positions égales au nombre de voies relié à des premières entrées d'un démultiplexeur dont les sorties sont reliés d'une part aux entrées - d'un soustracteur via un registre à décalage et d'autre part aux entrées + de ce soustracteur, les sorties de ce soustracteur étant reliées à des secondes entrées du démultiplexeur et à un registre à décalage à au moins trois positions relié à un additionneur à dichotomie.

L'interpolateur permet de choisir l'instant d'échantillonnage avec une résolution correspondant à 1/64 de la période d'horloge d'échantillonnage de sortie.

Vis-à-vis du temps de récupération de phase obligatoire et de la précision des spécifications de l'interface U RNIS, l'invention permet d'améliorer la solution décrite dans le document [1] en permettant d'obtenir une réalisation de faible surface et un faible coût en consommation de puissance, en fusionnant les fonctions de filtre de décimation et de récupération.

Brève description des dessins

- La figure 1, les figures 2A à 2C et la figure 3 illustrent des dispositifs de l'art connu ;
- la figure 4 illustre le filtre décimateur de l'invention ;
- la figure 5 illustre la fonction d'interpolation en fonction du temps ;
- les figures 6A à 6D illustrent quatre cas possibles d'interpolation ;
- la figure 7 illustre un exemple de réalisation du filtre décimateur de l'invention ;
- la figure 8 illustre un exemple de chronogramme des signaux apparaissant sur la figure 7 ;
- la figure 9 illustre le fonctionnement de l'interpolateur à dichotomie du filtre décimateur illustré sur la figure 7.

Exposé détaillé de modes de réalisation

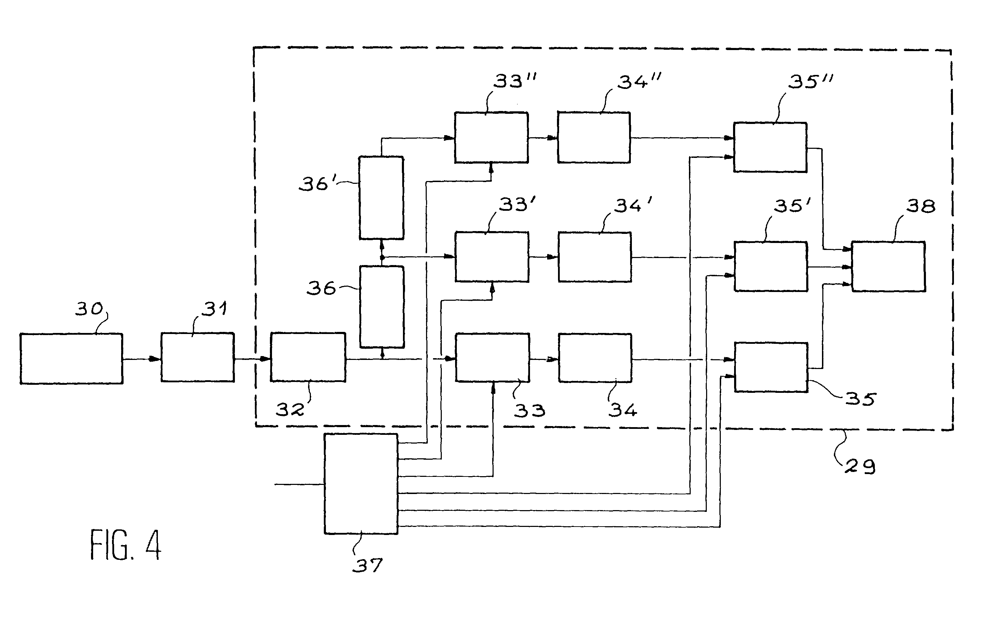

La figure 4 illustre un générateur 30 dont le signal de sortie est envoyé sur un modulateur delta-sigma 31, suivi du filtre décimateur 29 de l'invention. Ce filtre 29 comprend un intégrateur triple 32 dont la sortie est envoyée sur trois voies parallèles comportant chacune successivement un bloc de sous-échantillonnage 33 (33', 33"), un dérivateur 34(34', 34") et un multiplieur 35 (35', 35").

Les signaux d'entrée de chacune de ces voies sont décalés d'un délai égal à une période de la fréquence suréchantillonnée, c'est-à-dire 64 ns, grâce à un retard 36(36'). Chaque bloc de sous-échantillonnage 33, 33', 33" et chaque multiplieur 35, 35', 35" a une seconde entrée qui reçoit un signal en provenance d'une machine d'état 37. Les sorties des trois multiplieurs 35, 35', 35" sont envoyées dans un additionneur 38.

L'ensemble des trois multiplieurs 35, 35', 35" et de l'additionneur 38 permet de réaliser une interpolation linéaire.

On peut ainsi réaliser un filtre du troisième ordre, dont le temps d'établissement est égal à trois périodes d'horloge.

L'introduction selon l'invention d'une troisième voie en parallèle permet ainsi de réduire le temps de récupération et de fournir une précision d'une nanoseconde (c'est-à-dire 1/64 du débit de sortie).

Dans la machine d'état finie 37, les trois voies sont multiplexées selon la commande d'ajustement de phase. La sortie est la valeur interpolée entre les deux échantillons qui sont fiables.

Les trois blocs de sous-échantillonnage 33, 33' et 33" suivent les échantillons sous-échantillonnés ajustés en phase.

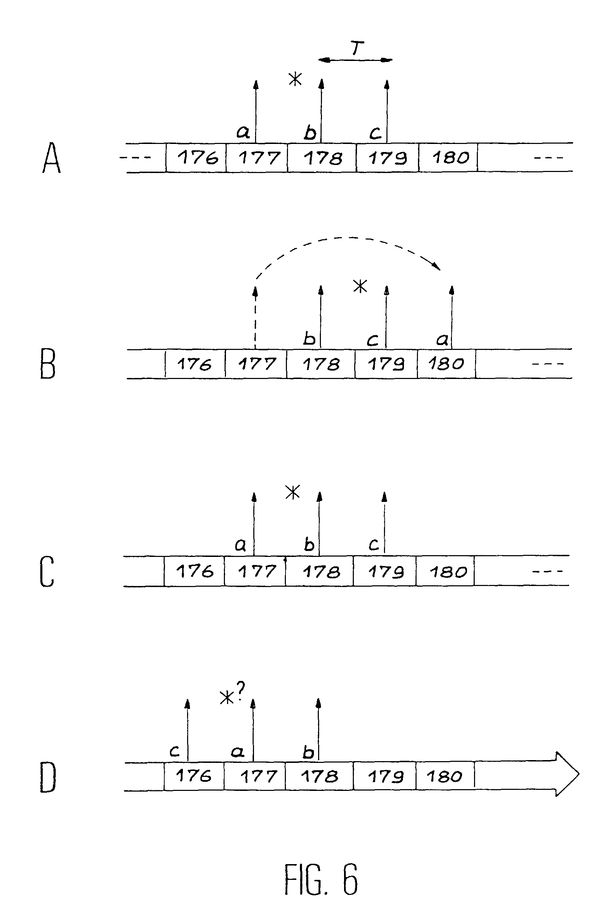

La fonction d'interpolation $y=f(x_1, x_2, x_3, \alpha)$ en fonction du temps, illustrée sur la figure 5, est choisie en fonction de la position des voies.

Lorsqu'une voie réalise un saut de phase, les deux autres voies, si elles sont fiables, fournissent l'échantillon de sortie interpolé au débit de l'horloge. Sur les figures 6A à 6D, le taux de suréchantillonnage est 192, et l'échelle de temps est représentée modulo 192, afin d'illustrer les sauts de phase de cette voie, l'étoile * illustrant la valeur de sortie, T étant la période de l'horloge d'échantillonnage.

Quatre états possibles sont représentés sur les figures 6A à 6D :

A) Défaut : les voies a et b sont utilisées pour interpoler la valeur de sortie par une fonction linéaire ;
B) Saut vers l'avant : la voie a est retardée de trois périodes suréchantillonnées et ne sera pas fiable pour la même période de temps à cause du filtre d'ordre 3.
C) Saut vers l'arrière : la phase de la voie a (la dernière) réduit sa phase de trois et la valeur de sortie est extrapolée des voies b et c.
D) Sauts successifs : un second saut vers l'arrière produit une extrapolation non fiable parce que le temps d'établissement de la voie a n'est pas encore terminé.

Ainsi toutes les commandes d'ajustement sont ignorées quand il n'y a pas au moins deux voies disponibles et fiables.

Si on désire éviter une telle caractéristique et sauter plus vite sans attendre une valeur stabilisée, on peut étendre la structure de l'invention à plus de trois voies.

Dans ce cas la voie « évité » ne sera réutilisée qu'après son temps d'établissement.

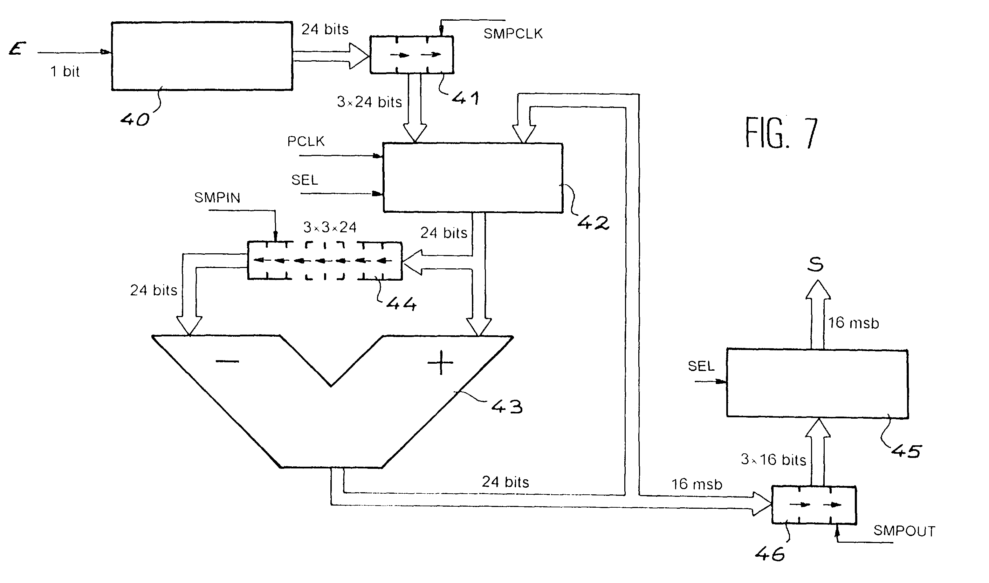

Pour diminuer la surface de la structure illustrée sur la figure 4, on peut modifier celle-ci comme illustré sur la figure 7. Celle-ci comprend un intégrateur triple 40, correspondant à trois intégrateurs en série, suivi d'un registre à décalage 41 à au moins trois positions (comme cela apparaît ci-dessus le nombre de voies est au moins égal à 3) relié aux premières entrées d'un démultiplexeur 42 dont les sorties sont reliées d'une part aux entrées - d'un soustracteur 43, par exemple 24 bits, via un registre à décalage 44, et d'autre part aux entrées + de ce soustracteur 43.

Les sorties de ce soustracteur 43 sont reliées à des secondes entrées du démultiplexeur 42 et à un registre à décalage 44 à au moins trois positions relié à un interpolateur 45 dit « à dichotomie ».

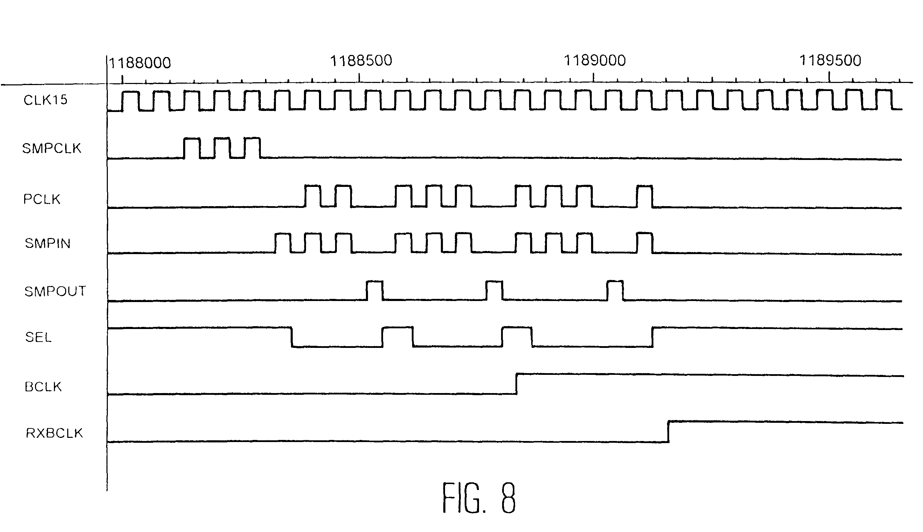

Les différents signaux apparaissant sur la figure 7 sont illustrés sur la figure 8, dans un exemple de fonctionnement.

L'intégrateur triple 40 travaille à un débit de suréchantillonnage (c'est-à-dire 15,36 Mhz).

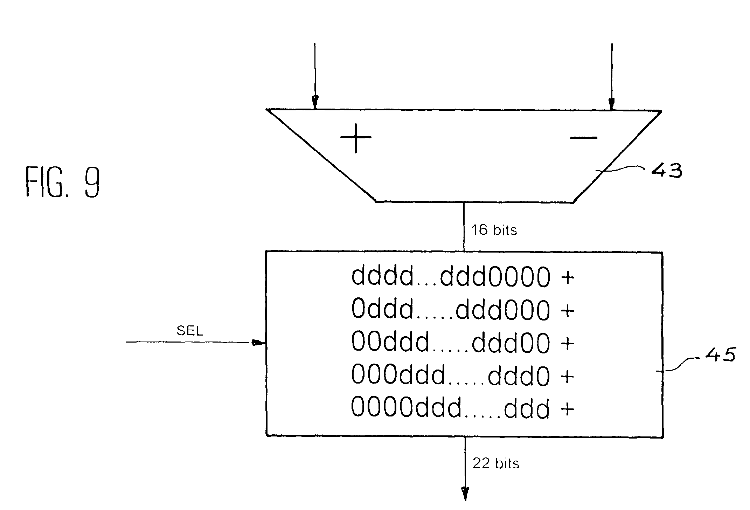

Le soustracteur 43 est utilisé pour réaliser les opérations de dérivation. Le registre de décalage 44 réalise la cellule mémoire. Sa longueur est égale au nombre de voies x ordre du filtre, par exemple 3x3. L'échantillon de sortie est fourni par un interpolateur formé par l'interpolateur à dichotomie 45 : celui-ci est tel que la différence entre deux échantillons est divisée par 2, 4, 8...64 (décalages de 6 bits), les résultats étant additionnés entre eux selon la position relative de la valeur interpolée, comme illustré sur la figure 9.

Dans chaque période BCLK, trois échantillons provenant de l'intégrateur triple 40 sont mémorisés et sélectionnés par le démultiplexeur 42. Le registre à décalage 44 mémorise les trois résultats d'opération de soustraction pour chaque voie et la sortie de démultiplexeur 42 est la valeur d'incrémentation, ou le nouvel échantillon d'entrée selon l'état prévu. Quand une valeur de sortie est calculée pour une voie (c'est-à-dire après trois boucles dans l'additionneur), il est mémorisé dans l'interpolateur 45 et une nouvelle valeur d'entrée est introduite dans la boucle de traitement. Cette réalisation utilise seulement les 16 bits les plus significatifs parmi les 24 pour calculer la valeur de sortie.

Dans un tel exemple de réalisation, l'algorithme de récupération de phase est plus précis dans l'estimation du retard de phase et les valeurs de sortie présentent moins de distorsion. Si la fréquence d'échantillonnage est suffisamment élevée (approximation linéaire du signal d'entrée), l'interpolation fournit un gain de distorsion G = 20 log 64 = 36 dB.

REFERENCE

[1] « A Digital Signal Processor For An ANSI Standard ISDN Transceiver » de Oscar Agazzi, Taiho Koh, Syed S. Haider, Robert W. Walden, Daniel R. Cassiday, Gene A. Wilson, T. Mariano Lalumia, Christine M. Gerveshi, Jitendra Kumar, Ronald E. Crochière, Robert F. Shaw, Ralph A. Wilson, William R. McDonald, Noah L. Gottfried, Nallepili S. Ramesh et Roy B. Blake (IEEE Journal Of Solid-State Circuits, Volume 24, numéro 6, décembre 1989, pages 1605 à 1611)

[2] « Two-Phase Decimation And Jitter Compensation In Full-Duplex Data Transceivers » de Oscar E. Agazzi, Vladimir Friedman, Christine M. Gerveski, David L. Price, Gene A. Wilson, Jit Kumar, Robert F. Shaw, Noah L. Gottfield, Nallepilli S. Ramesh, William R. McDonald, Marvin L. Heiskanen, Roy B. Blake (IEEE, 1992, pages 1717-1720)

**Revendications**

1. Filtre décimateur comprenant au moins trois filtres identiques sous-échantillonnés (33, 34 ; 33', 34' ; 33", 34") déphasés entre eux et disposés en parallèle, caractérisé en ce qu'il comprend un interpolateur (35, 35', 35", 38) disposé en sortie de ceux-ci.

2. Filtre décimateur selon la revendication 1 comprenant un intégrateur triple (32) dont la sortie est envoyée sur trois voies parallèles comportant chacune successivement un bloc de sous-échantillonnage (33, 33', 33"), un dérivateur (34, 34', 34") et un multiplieur (35, 35', 35"), les sorties des trois multiplieurs (35, 35', 35") étant envoyées dans un additionneur (38), les signaux d'entrée de chacune de ces voies étant décalés d'un délai égal à une période de la fréquence suréchantillonnée grâce à des retards (36, 36'), chaque bloc de sous-échantillonnage (33, 33',33") et chaque multiplieur (35, 35', 35") ayant une seconde entrée qui reçoit un signal en provenance d'une machine d'état (37).

3. Filtre décimateur selon la revendication 1, comprenant un intégrateur triple (40), suivi d'un registre à décalage à au moins trois positions (41) relié à des premières entrées d'un démultiplexeur (42), dont les sorties sont reliées d'une part aux entrées - d'un soustracteur (43) via un registre à décalage (44), et d'autre part aux entrées + de ce soustracteur (43), les sorties de ce soustracteur (43) étant reliées à des secondes entrées du démultiplexeur (42) et à un registre à décalage à au moins trois positions (44) relié à un interpolateur (45) à dichotomie.

FIG. 1

FIG. 2 A

FIG. 2 B

FIG. 2 C

6

FIG. 3

FIG. 5

FIG. 4

FIG. 6

FIG. 7

FIG. 8

EP 0 971 480 A1

FIG. 9

```
        +                    −
                                      43

            16 bits

   dddd...ddd0000 +
   0ddd.....ddd000 +
SEL 00ddd.....ddd00 +        45
   000ddd.....ddd0 +
   0000ddd.....ddd +

            22 bits
```

**Office européen des brevets**

## RAPPORT DE RECHERCHE EUROPEENNE

Numéro de la demande

EP 99 40 1652

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (Int.Cl.7) |
| A | US 4 983 975 A (SUGINO KIMIHIRO ET AL) 8 janvier 1991 (1991-01-08) * le document en entier * --- | 1-3 | H03H17/06 |
| A | BI G ET AL: "RATIONAL SAMPLING RATE CONVERSION STRUCTURES WITH MINIMUM DELAY REQUIREMENTS" IEE PROCEEDINGS E. COMPUTERS & DIGITAL TECHNIQUES, vol. 139, no. 6 PART E, 1 novembre 1992 (1992-11-01), pages 477-485, XP000331211 * le document en entier * ----- | 1-3 | |
| | | | **DOMAINES TECHNIQUES RECHERCHES (Int.Cl.7)** H03H |

Le présent rapport a été établi pour toutes les revendications

| Lieu de la recherche | Date d'achèvement de la recherche | Examinateur |
|---|---|---|
| LA HAYE | 19 octobre 1999 | Coppieters, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 99 40 1652

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-10-1999

| Document brevet cité au rapport de recherche | Date de publication | Membre(s) de la famille de brevet(s) | Date de publication |
|---|---|---|---|
| US 4983975 A | 08-01-1991 | JP 1254024 A | 11-10-1989 |

Pour tout renseignement concernant cette annexe : voir Journal Officiel de l'Office européen des brevets, No.12/82

EPO FORM P0460